(19) Europäisches Patentamt
European Patent Office
Office européen des brevets

(11) **EP 4 769 850 A2**

(12) **EUROPEAN PATENT APPLICATION**

(43) Date of publication:
**01.07.2026 Bulletin 2026/27**

(21) Application number: 25225525.2

(22) Date of filing: **19.12.2025**

(51) International Patent Classification (IPC):
*H01S 5/125* (2006.01)    *H01S 5/14* (2006.01)
*H01S 5/40* (2006.01)    *H01S 5/026* (2006.01)
*H01S 5/10* (2021.01)

(52) Cooperative Patent Classification (CPC):
**H01S 5/142; H01S 5/0287; H01S 5/125;
H01S 5/4062; H01S 5/4087;** H01S 5/026;
H01S 5/0265; H01S 5/1032; H01S 5/4012

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **31.12.2024 US 202419006645**

(71) Applicant: **Cisco Technology, Inc.**
**San Jose, CA 95134-1706 (US)**

(72) Inventors:
• **Huang, Xue**
**San Jose, 95134-1706 (US)**
• **Nowell, Mark**
**San Jose, 95134-1706 (US)**
• **Ketelsen, Len**
**San Jose, 95134-1706 (US)**
• **Chen, Long**
**San Jose, 95134-1706 (US)**

(74) Representative: **Noble, Nicholas et al**
**Kilburn & Strode LLP**
**Lacon London**
**84 Theobalds Road**
**London WC1X 8NL (GB)**

(54) **A LOW-COST LASER GENERATING MULTIPLE WAVELENGTHS**

(57) In one embodiment, the disclosure relates to an electro-optical device that includes an optical gain chip that includes; a gain material, the gain material having a gain region, the optical gain chip that includes: N gain chip waveguides; a photonic integrated circuit (PIC) that includes a plurality of layers and a plurality of components, wherein the PIC defines M sections; N external laser cavities; P PIC waveguides; and B distributed Bragg reflector (DBR) rings, wherein each of the N external laser cavities is defined by one of the P PIC waveguides and one of the B DBR rings; and N laser cavities, wherein each laser cavity of the N laser cavities comprises one of the N external laser cavities and one of the N gain chip waveguides.

**EP 4 769 850 A2**

**Description**

FIELD

This disclosure relates generally to the fields of photonic integrated circuits, tunable lasers, and coherent optical telecommunication systems.

BACKGROUND

Coherent optical telecommunications systems and photonic integrated circuits make extensive use of tunable lasers that are advantageously mass-produced in various configurations for various purposes.

BRIEF DESCRIPTION OF THE FIGURES

Unless specified otherwise, the accompanying drawings illustrate aspects of the innovations described herein. Referring to the drawings, wherein like numerals refer to like parts throughout the several views and this specification, several embodiments of presently disclosed principles are illustrated by way of example, and not by way of limitation. The drawings are not intended to be to scale. A more complete understanding of the disclosure may be realized by reference to the accompanying drawings in which:

Figure 1 is a diagram of an electro-optical system that includes a multiple-wavelength laser source based on distributed Bragg reflector (DBR) rings, the laser source includes a gain chip and a photonic integrated circuit (PIC) according to an exemplary embodiment of the disclosure.
Figure 2 is a diagram of a DBR ring according to an exemplary embodiment of the disclosure.
Figure 3 is a diagram of an alternative design of an electro-optical system that includes a multiple-wavelength laser source based on DBR rings, the laser source includes an array of gain chips and a PIC according to an exemplary embodiment of the disclosure.
Figure 4 is a diagram of an alternative design of an electro-optical system that includes a multiple-wavelength laser source based on DBR rings and ring modulators, the laser source includes a gain chip and a PIC according to an exemplary embodiment of the disclosure.
Figure 5 is a diagram of an alternative design of an electro-optical system that includes a multiple-wavelength laser source based on DBR rings, the laser source includes a gain chip and a PIC, wherein the PIC is operable to reflect all light incident from the gain chip according to an exemplary embodiment of the disclosure.
Figure 6 is a diagram of an alternative design of a multiple-wavelength laser source based on DBR rings, wherein multiple wavelengths are multiplexed on a single waveguide according to an exemplary embodiment of the disclosure.
Figure 7 is a diagram of an electro-optical system that includes an alternative design of a multiple-wavelength laser source based on DBR rings and ring modulators, wherein multiple wavelengths are multiplexed on a single waveguide according to an exemplary embodiment of the disclosure.
Figure 8 is a diagram of an alternative design of an electro-optical system that includes a multiple-wavelength laser source based on DBR rings and ring modulators that includes an array of gain chips and a PIC, wherein at least two wavelengths are multiplexed on one of a plurality of waveguides according to an exemplary embodiment of the disclosure.

OVERVIEW

In part, in one aspect, the disclosure relates to an electro-optical device that includes an optical gain chip that includes a gain material, the gain material having a gain region, the optical gain chip includes $N$ gain chip waveguides; a photonic integrated circuit (PIC) includes a plurality of layers and a plurality of components, wherein the PIC defines $M$ sections; $N$ external laser cavities; $P$ PIC waveguides; and $B$ distributed Bragg reflector (DBR) rings, wherein each of the $N$ external laser cavities is defined by one of the $P$ PIC waveguides and one of the $B$ DBR rings; and $N$ laser cavities, wherein each laser cavity of the $N$ laser cavities includes one of the $N$ external laser cavities and one of the $N$ gain chip waveguides. In some embodiments, $M$, $P$, and $B$ are all positive integers greater than or equal to 2, wherein each laser cavity of the $N$ laser cavities transmits one central wavelength that differs from a central wavelength transmitted by each of the laser cavities. In some embodiments, $N$ is 1 and $P$ is 1.

In part, in one aspect, the disclosure relates to a method that includes transmitting $N$ laser beams back and forth between a gain chip and $N$ external laser cavities, wherein the gain chip provides optical gain, wherein a wavelength of each of the $N$ laser beams is tunable within a range; selecting, using $B$ DBR rings, a center wavelength from the range of wavelengths for each of the $N$ laser beams; transmitting $N$ laser beams, each of the $N$ laser beams having a selected center wavelength; selecting, using one or more parameters of each of the $B$ DBR rings, between a transmission direction and a reflection direction, wherein the transmission direction is orientable towards $N$ laser outputs; and transmitting each of the $N$ laser beams having its respective selected center wavelength from one of the $N$ laser outputs.

EXAMPLE EMBODIMENTS

In part, in one aspect, the disclosure relates to a laser source operable to generate multiple wavelengths of light. In one aspect, in modes of wavelength division multiplexing (WDM) optical communication such as coarse wavelength division multiplexing (CWDM), dense WDM (DWDM), local area network WDM (LAN WDM), and in FR4, LR4, or other optical modules where multiple optical channels share a fiber for transmission, each channel has its own unique optical carrier wavelength. Therefore, multiple lasers are required to provide multiple optical carrier wavelengths that match a WDM wavelength grid. In one aspect, transmitters based on electro-absorption modulated lasers (EMLs) and photonic integrated circuits (PICs) are widely used for high speed WDM optical communications. In one aspect, for laser sources based on distributed feedback (DFB) lasers, a separate DFB laser may be required for each optical carrier wavelength. In one aspect, a use of multiple discrete lasers results in a higher cost, larger footprint, higher manufacturing complexity, and a lower yield. In another aspect, a DFB array fabricated on a single die may reduce a manufacturing complexity with optical alignment of all laser channels requiring only a single step but may still exhibit a high cost and a low yield.

In various embodiments, a PIC typically includes multiple layers such as one or more of the following: a substrate layer, a silicon-on-insulator (SOI) layer, a waveguide layers, metals or other electrically conductive materials, oxide layers, and passivation layers and others. In various embodiments, the PIC includes various optical, electrical, and electro-optical components that may be arranged in various sections, regions or locations on the PIC. Applicants have discovered that it is advantageous for certain components to be positioned in adjacent or neighboring regions that share one or more layers of the PIC and are exposed to some or all of the same fabrication stages and associated temperature changes, etching processes, deposition processes and other steps and environmental and other parameters. For example, a laser that include a loop and a modulator that includes a separate loop may share some underlying layers of the PIC and be located in sections that are adjacent each other or otherwise positioned near each other such that they are in optical communication via one or more waveguides.

In still another aspect, a comb laser that provides a single beam of combined wavelengths may be optically coupled to a transmitter PIC through a single optical coupling port. In one aspect, in a comb laser source, wherein a ring modulator in a transmitter module may pick and modulate a laser wavelength of a channel, may not require an additional multiplexer stage prior to an output fiber coupling and so may provide a compact configuration. However, in one aspect, a comb laser source that meets typical constraints for wavelength spacing control, relative intensity noise (RIN) of each wavelength, and mode-hop free operation may not meet cost constraints. Moreover, in such a system a ring modulator may require additional electrical power to compensate for resonant wavelength changes due to fabrication process variations.

In part, in one aspect, a laser source as disclosed herein includes an external cavity laser, wherein a distributed Bragg reflector (DBR) ring forms an end or a termination of an external portion of a laser cavity for each wavelength of light generated by the laser source. In one aspect, each DBR ring is integrated onto a photonic integrated circuit (PIC), wherein the PIC may include other optical elements such as optical transmitters, a LiDAR system, optical sensors, a system-on-a-chip, optical multiplexers, or other integrated optical elements. In one aspect of the disclosure, a gain chip, operable to induce an optical gain under an electrical bias and optically coupled to the PIC, includes a plurality of waveguides and a highly reflective facet that terminates a plurality of laser cavities. In one aspect, a plurality of gain chips may be optically coupled to the PIC. In one aspect, a waveguide on a PIC or a gain chip may form part of a single laser cavity, or in another aspect a waveguide on a PIC or a gain chip may form part of multiple laser cavities; similarly, a waveguide on a PIC or a gain chip may guide one wavelength of light or multiple wavelengths of light.

In part, in one aspect, an optical transmitter that is integrated on a PIC may include a plurality of ring modulators. In one aspect, a ring modulator, a DBR ring, and/or a portion of a waveguide that forms a part of a laser cavity may be in thermal communication with a thermo-optical phase shifter (TOPS) that is operable to offset a shift in a resonant wavelength of light due to a change in an ambient temperature, a fabrication process variation, or other condition.

In one aspect of the disclosure, a multiple-wavelength laser source as disclosed herein, based on DBR rings and based on a single gain chip integrated onto a PIC or a plurality of gain chips multiplexing multiple wavelengths of light integrated onto a PIC, may be characterized by a smaller footprint, a lower electrical power consumption simplified control for wavelength tuning, and a simplified integration process when compared to various other multiple-wavelength laser sources based, for example, on distributed feedback (DFB) lasers or integration methods requiring optical lenses or optical isolators. In one aspect, a DBR ring and a ring modulator integrated as disclosed herein provide an automatic synchronization of phase or wavelength control that simplifies physical structure of a laser source, reduces a complexity of a control loop, and reduces electrical power consumption. In other embodiments disclosed herein, instead of coupling individual channels with individual gain chip dies in a conventional approach, a coupling of all channels shared a same gain chip die may be finished in a single integration step. Furthermore, in various embodiments the PIC includes a substrate such as a shared substrate or common substrate.

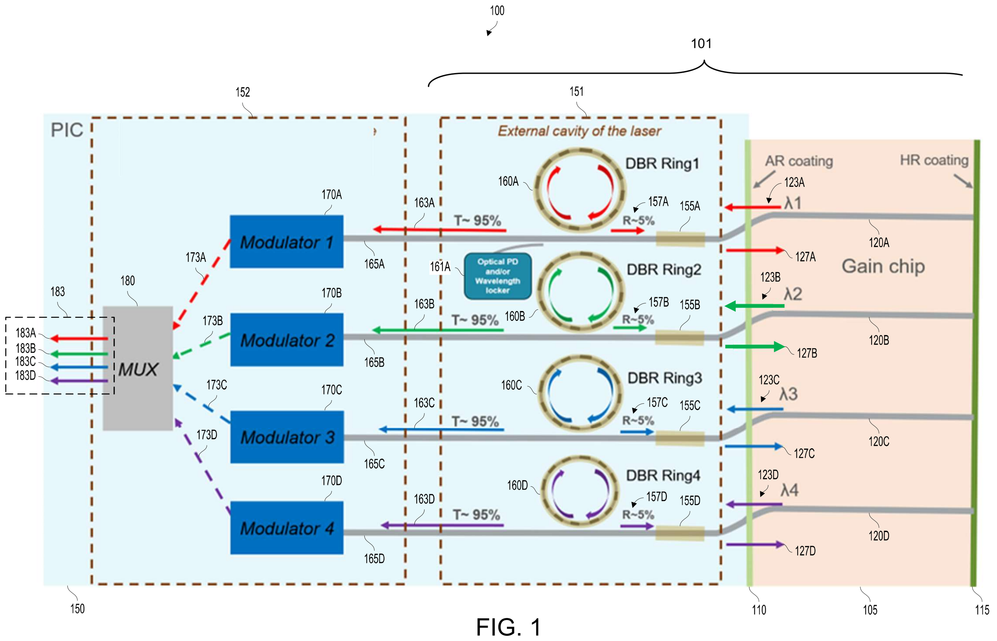

Refer now to the example embodiment of Figure 1 which shows an electro-optical system 200 that includes a multiple-wavelength laser source 101. In various embodiments, the multiple-wavelength laser source may be suitable for wavelength division multiplexing (WDM). The laser source includes a gain chip 105 that is optically coupled to a photonic integrated circuit (PIC) 150. In most embodiments, a plurality of optical waveguides span the gain chip and the PIC to form a plurality of laser cavities. For example, a first waveguide 120A on the gain chip is optically coupled to a first PIC waveguide 165A to form a first laser cavity, a second waveguide 120B on the gain chip is optically coupled to a second PIC waveguide 165B to form a second laser cavity, a third waveguide 120C on the gain chip is optically coupled to a third PIC waveguide 165C to form a third laser cavity, and a fourth waveguide 120D on the gain chip is optically coupled to a fourth PIC waveguide 165D to form a fourth laser cavity.

The embodiment of Figure 1 and various other embodiments include at least one gain chip waveguide, at least one laser cavity, at least one external laser cavity, and at least one PIC waveguide. In various embodiments, N denotes a number of gain chip waveguides, a number of laser cavities, and a number of eternal laser cavities in an electro-optical system; in the embodiment of Figure 1 , N is four. In various embodiments, P denotes a number of PIC waveguides in an electro-optical system; in the embodiment of Figure 1 , P is four. In some embodiments, each DBR ring includes a loop waveguide optically coupled to one of the P PIC waveguides, wherein the loop waveguide has a first loop dimension; and one or more DBR disposed along one or more sections of the loop waveguide.

In most embodiments, each of the first, second, third, and fourth laser cavities carries a different wavelength of light. Furthermore, while the embodiment of Figure 1 shows a multiple-wavelength source that includes four laser cavities each operable to carry a different wavelength of light, various other embodiments may include a number of laser cavities less than four or a number of laser cavities more than four. Also, while the embodiment of Figure 1 shows each of the four laser cavities corresponding to a single gain chip, various other embodiments may exhibit a plurality of gain chips coupled to the PIC wherein each of the plurality of laser cavities may correspond to a different gain chip in arbitrary configurations.

In most embodiments, the gain chip 105 is operable to provide an optical gain under an electrical bias. In some embodiments, the gain chip is fabricated from III-V semiconductor materials. In various embodiments, a gain region of the gain chip may include quantum well (QW) or quantum dot (QD) structures.

In many embodiments of the disclosure, a first facet 110 of the gain chip 105 includes a surface at which the gain chip is coupled to the PIC and in most embodiments the first facet is coated an anti-reflective (AR) coating 110. In many embodiments of the disclosure, including the embodiment of Figure 1 and other embodiments, an AR coating may provide a reflectivity of about or less than about 0.1 %. A second facet 115 of the gain chip 105 includes a first termination of each of the first, second, third, and fourth laser cavities and so is coated in a highly reflective (HR) coating with a typical reflectivity higher than about 98.0%. In most embodiments of the disclosure, a distributed Bragg reflector (DBR) ring forms a second termination of each of the plurality of laser cavities. The embodiment of Figure 1 and various other embodiments include at least one DBR ring. In various embodiments, B denotes a number of DBR rings in an electro-optical system. In the electro-optical system of Figure 1 , B is four.

For example, in Figure 1 a first DBR ring 160A terminates the first laser cavity, a second DBR ring 160B terminates the second laser cavity, a third DBR ring 160C terminates the third laser cavity, and a fourth DBR ring 160D terminates the fourth laser cavity. As such, a region of the PIC that includes the DBR rings 160A-D and a corresponding portions of each of the PIC waveguides 165A-D that include an external laser cavity for each of the lasers as shown in external laser cavity section 151 of the PIC.

In various embodiments, a DBR ring terminates a laser cavity by reflecting a portion of light in the cavity back toward an opposite, reflecting termination. For example, with a choice of design parameters, the first DBR ring 160A is operable to reflect a first reflected portion 157A of incident light 123A back into the gain chip, the second DBR ring 160B is operable to reflect a second reflected portion 157B of incident light 123B back into the gain chip, the third DBR ring 160C is operable to reflect a third reflected portion 157C of incident light 123C back into the gain chip, and the fourth DBR ring 160D is operable to reflect a fourth reflected portion 157D of incident light 123D back into the gain chip. A laser cavity includes a continuous reflection between terminations. For example, a first laser cavity includes light 123A in a first direction and light 127A in a second direction, a second laser cavity includes light 123B in a first direction and light 127B in a second direction, a third cavity includes light 123C in a first direction and light 127C in a second direction, and a fourth laser cavity includes light 123D in a first direction and light 127D in a second direction.

In many embodiments, the first DBR ring transmits a first transmitted portion 163A, the second DBR ring transmits a second transmitted portion 163B, the third DBR ring transmits a third transmitted portion 163C, and the fourth DBR ring transmits a fourth transmitted portion 163D. In some embodiments, the transmitted portions 163A-D are transmitted to an optical electro-optical device 152 on the PIC. The electro-optical device 152 can be various types of assemblies, systems, subsystems, and devices. In some embodiments, the elector-optical device 152 may include a receiver, a transmitter, optical modulator, an optical sensor, a LiDAR-based component, a system-on-chip, a local oscillator, an optical waveguide and combinations thereof. In other embodiments, the transmitted portions 163A-D may be transmitted into other optical elements that are integrated onto the PIC, such as optical sensors or LiDAR components. In other embodiments, the transmitted portions 163A-D may be transmitted into a system on a chip (SoC) that is integrated onto the PIC. In still other embodiments, the transmitted portions 163A-D may be guided off the PIC by external optical elements. In various embodiments, one or more or all of the DBR rings includes a TOPS. In various embodiments, the TOPS is configured to adjust the resonant frequency/wavelength of the DBR ring.

In some embodiments of the disclosure, a thermo-optical phase shifter (TOPS) element or a local heater may overlap a segment of each of the waveguides 165A-D that includes laser cavities. For example, in Figure 1, a first TOPS 155A overlaps a region of the first PIC waveguide 165A, a second TOPS 155B overlaps a region of the second PIC waveguide 165B, a third TOPS 155C overlaps a region of the third PIC waveguide 165C, and a fourth TOPS 155D overlaps a region of the fourth PIC waveguide 165D. Each of the TOPS elements 155A-D is operable, with or without DBR ring TOPS adjustment, to adjust a phase of light in a laser cavity to change the optical frequency/wavelength, or compensate for changes in a resonant frequency or wavelength due to changes in ambient temperature.

In some embodiments, at least one of the PIC waveguides 165A-D may be additionally coupled to an optical photo detector, wavelength locker, or other optical element. For example, in the embodiment of Figure 1, an optical element 161A is optically coupled to the first PIC waveguide 165A. In some embodiments, an additional optical element coupled to a PIC waveguide may be operable to monitor an optical wavelength of a laser cavity.

In the embodiment of Figure 1, the electro-optical device 152 may be various devices such as for example, an optical transmitter that includes a plurality of modulators 170A-D that receive transmitted portions 163A-D. For example, a first modulator 170A receives the first transmitted portion 163A to produce a first modulated signal 173A, a second modulator 170B receives the second transmitted portion 163B to produce a second modulated signal 173B, a third modulator 170C receives the third transmitted portion 163C to produce a third modulated signal 173C, and a fourth modulator 170D receives the fourth modulated portion 163D to produce a fourth modulated signal 173D. In most embodiments featuring an optical transmitter, a multiplexer 180 receives and multiplexes the modulated signals 173A-D into a single signal 183 that includes four wavelengths corresponding to the modulated signals 173A-D. Compared with conventional approaches wherein DFB lasers couple to transmitter channels via lenses and isolators, embodiments as disclosed herein that use individual gain chips that include one or more waveguides have greatly simplified manufacturing processes. Moreover, a yield and a cost of fabrication of multi-channel gain chips without DFB lasers are significantly improved compared to a yield and a cost of fabrication of DFB arrays. In some embodiments, one or more waveguides on a gain chip and/or a PIC may be arranged to be in parallel or substantially parallel.

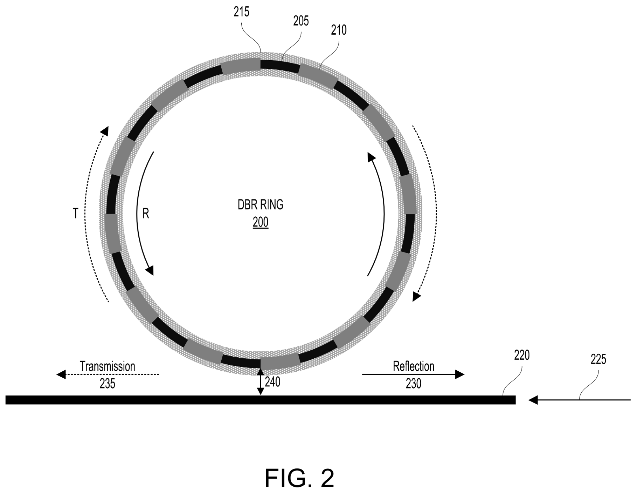

Refer now to the example embodiment of Figure 2 which shows a distributed Bragg reflector (DBR) ring 200 in isolation that is optically coupled to a waveguide 220 by proximity. The DBR ring includes a ring resonator 205 and a DBR 210. The ring resonator and the DBR can be formed on the same fabrication layer, so the DBR grating features are fabricated on the ring itself. Or the DBR can be on a fabrication layer above or below ring resonator such that the DBR 210 is optically coupled to the ring resonator 205. In most embodiments, the ring resonator is a circular or elliptical waveguide, or a closed loop of any shape. In most embodiments, the DBR includes a grating, or series of alternating segments of optical materials, each with a different index of refraction. The circular DBR may cover all, substantially all, or some portion of the ring resonator 205. For example, the circular DBR 210 may be a circular arc covering 99 % of the ring resonator or 50 % of the ring resonator or some other percentage in some embodiments. In various embodiments, the circular DBR 210 is a continuous and closed loop. The various ring resonators and other ring-based device or components disclosed herein may include an optical path that is elliptical, circular, or other curved shapes that form a closed loop suitable for operating as a laser cavity or modulator or another electric-optical device or other component disclosed herein.

In most embodiments, the DBR ring 200 is operable to selectively filter an incident optical wave 225. The DBR ring 200 supports a resonant mode at a particular frequency and by a choice of a DBR grating coupling constant and a coupling efficiency between the DBR ring 200 and the waveguide 220, an amount of reflection 230 in a direction opposite to that of the incident wave 225 may be tuned, or equivalently an amount of transmission 235 an a same direction as that of the incident wave 225 may be tuned. In many embodiments, the coupling efficiency between the DBR ring 200 and the waveguide 220 varies directly with a distance 240 between the DBR ring and the waveguide 220.

In various embodiments, while a DBR ring structure and the second waveguide 220 may be physically fixed after fabrication, a coupling coefficient between the DBR ring and the waveguide may still be tunable, and so an amount of reflection 230 or transmission 235 of the DBR ring may be tunable even after fabrication. For example, in some embodiments, with additional micro-electro-mechanical systems (MEMS) components, the distance 240 may be adjusted. In such embodiments, the waveguide 220 may be pushed laterally away from or pulled laterally toward the DBR ring if the waveguide 220 and the DBR ring are in a same fabrication layer, or the waveguide and the DBR ring may be pushed vertically away from or pulled vertically toward the DBR ring if the waveguide and the DBR ring are in different fabrication layers. The DBR is operable to tune an amount of optical transmission out of the cavity based on a choice of various design parameters of the DBR or various optical coupling coefficients. In another aspect, the DBR ring may be heated by a local heater or thermo-optical phase shifter (TOPS) to compensate for an optical phase shift due to a temperature change or to tune the optical frequency of the laser.

In some embodiments, the DBR ring may additionally include a circular thermo-optical phase shifter (TOPS) 215 on a fabrication layer above or below the ring resonator 205 and the circular DBR 210 such that the TOPS is in thermal communication with the ring resonator and the circular DBR. The TOPS is operable to adjust a phase of optical waves in the DBR ring to adjust a resonant frequency or wavelength, sometimes for the purpose of offsetting changes in resonant frequency or wavelength due to changes in ambient temperature.

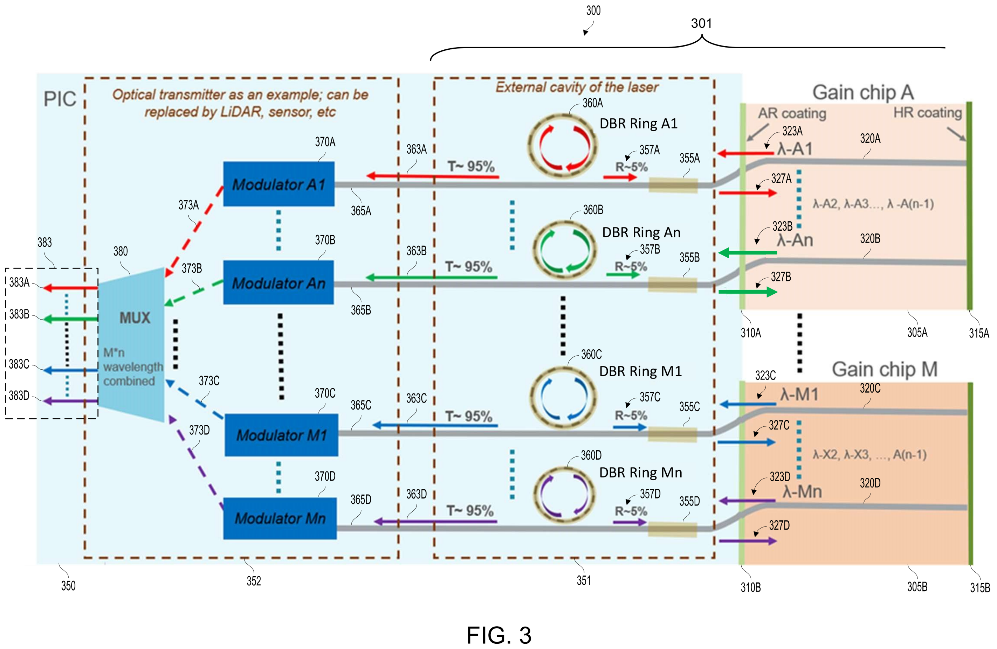

Refer now to the example embodiment of Figure 3 which shows an alternative implementation of an electro-optical system 300 that includes multiple-wavelength laser source 301. In some embodiments of the disclosure, depending on a design requirement on a laser channel spacing and a number of laser channels for a wavelength division multiplexing (WDM) application, the multiple-wavelength laser source shown in Figure 2 may be extended such that a plurality of gain chips, each chip supporting a plurality of laser channels, integrated with a PIC, as shown in the example embodiment of Figure 3.

In Figure 3, a plurality of gain chips numbering $M$ are shown in an abbreviated manner, such that only a first gain chip 305A and a last gain chip 305B are drawn. In the embodiment, each of the plurality of gain chips is optically integrated to a PIC 350. Each of the $M$ gain chips includes a first facet that coincides with a surface of coupling between a gain chip and the PIC 350, as well as a second facet that terminates a laser cavity spanning a gain chip and the PIC 350. For example, in the embodiment of Figure 3, the first gain chip 305A has a first facet 310A and a second facet 315A, and the last gain chip 305B has a first facet 310B and a second facet 315B. In several embodiments, a first facet of each of the plurality of gain chips is coated with an anti-reflective (AR) coating while a second facet of each of the gain chips is coated with a highly reflective (HR) coating. Finally, each of the $M$ gain chips includes a plurality of parallel, gain medium waveguides. In some embodiments, each of the gain chip waveguides may provide one or more WDM channel carriers.

One advantage of the disclosure is that you can create multiple wavelength carriers with a single gain chip. The limit of the different carriers will be set by the gain curve of the gain chip. In various embodiments, is a given design specifies using more wavelengths than a single gain chip can provide, then additional gain chips may be used. In such embodiments, given that the gain chips selected support at least two wavelengths, a given design will use using fewer than one gain chip per wavelength. Compared with conventional approaches wherein DFB lasers couple to transmitter channels via lenses and isolators, embodiments as disclosed herein that use individual gain chips that include one or more waveguides have greatly simplified manufacturing processes. Moreover, a yield and a cost of fabrication of multi-channel gain chips without DFB lasers are significantly improved compared to a yield and a cost of fabrication of DFB arrays.

As shown in Figure 3, each of the $M$ gain chips includes an array of $n$ waveguides. For example, the first gain chip 305A includes a first waveguide 320A and a last or $n$th waveguide 320B, and the last gain chip 305B includes a first waveguide 320C and a last or $n$th waveguide 320D. Each of the $n$ waveguides on each of the $M$ gain chips constitute a part of a laser cavity for a particular optical frequency, and each waveguide on each gain chip transmits to the PIC and receives from the PIC some amount of optical power as a lasing occurs in a laser cavity. For example, the first waveguide 320A of the first gain chip 305A transmits an optical power 323A and receives an optical power 327A, and the $n$th waveguide 320B of the first gain chip 305A transmits an optical power 323B and receives an optical power 327B. In addition, the first waveguide 320C of the last gain chip 305B transmits an optical power 323C and receives an optical power 327C, and the $n$th waveguide 320D of the last gain chip 305B transmits an optical power 323D and receives an optical power 327D. Similarly, each of the $n$ waveguides of each of the $M$ - 2 gain chips that are not drawn in Figure 3 transmit and receive optical power to and from the PIC as a lasing occurs in each laser cavity.

In the embodiment of Figure 3, a plurality of waveguides on the PIC form an external portion of each of the laser cavities on each of the gain chips. In Figure 3, a first PIC waveguide 365A forms an external portion of a laser cavity with the first waveguide 320A of the first gain chip 305A, an $n$th PIC waveguide 365B forms an external portion of a laser cavity with the $n$th waveguide 320B of the first gain chip 305A, an $[M(n - 1) + 1]$th PIC waveguide 365C forms an external portion of a laser cavity with the first waveguide 320C of the $M$ th gain chip 305B, and an $(Mn)$th PIC waveguide 365D forms an external portion of a laser cavity with the $n$ th waveguide 320D of the $M$th gain chip. In a similar fashion to the embodiment of Figure 1, a DBR ring, such as the DBR ring of Figure 2, terminates each laser cavity, and a portion of each laser cavity may be in thermal communication with a TOPS element on the PIC. Figure 3 depicts a DBR ring 360A and TOPS element 355A for a first laser cavity, a DBR ring 360B and TOPS element 355B for an $n$ th laser cavity, a DBR ring 360C and TOPS element 355C for an $[M(n - 1) + 1]$th laser cavity, and a DBR ring 360D and TOPS element 355D for an $(Mn)$th laser cavity.

The PIC 350 includes an external cavity region or external cavity section 351 that includes various DBR rings wherein the DBR rings may be arranged or disposed in a particular region of the PIC and in optical communication with multi-waveguides of a gain chip or multiple gain chips with each such gain chip having at least one waveguide. The various DBR rings may be arranged in a group or cluster such as a set of DBR rings with one ring below another until the last DBR ring in the set is reached. The DBR rings may be in a linear arrangement. In one embodiment, the center of a given DBR ring is a co-linear with a center of another DBR ring. In another embodiment, the center of each of two or more DBR rings are all substantially co-linear or co-linear with a center of another DBR ring. The waveguides may be allocated such that at least one waveguide is in optical communication with the DBR ring for each laser in some embodiments. The arrangement and/or placement of the rings is very flexible. A given BDR ring can placed at any location relative to another ring or a given location or position.

Each of the DBR rings in the embodiment including a subset of which 360A-D that are drawn in the Figure, acting as a cavity termination, are operable to act as wavelength selective filters and reflect a portion of optical power 357A, 357B, 357C, 357D back to a gain chip and transmit a portion of optical power 363A, 363B, 363C, 363D to an optical transmitter 352 or other optical system integrated on the PIC 350. In a fashion similar to the embodiment of Figure 1, the optical transmitter 352 may include a plurality of *Mn* modulators that receive the *Mn* transmitted portions from the laser cavities.

In some embodiments, each of the B DBR rings is approximately circular and defines a DBR center, wherein all of the B DBR centers are approximately aligned with a first axis, wherein the first axis is approximately perpendicular to one or more of the P PIC waveguides. The B distributed Bragg reflector (DBR) rings may be substantially aligned relative to a second axis, wherein the second axis is substantially parallel with one PIC waveguide.

In the embodiment of Figure 3, a subset 370A, 370B, 370C, 370D of the *Mn* modulators are shown. In most embodiments, the *Mn* modulators yield *Mn* modulated signals, a subset 373A, 373B, 373C, 373D of which are shown in the Figure. In most embodiments, the optical transmitter 352 further includes a multiplexer 380 operable to multiplex the *Mn* modulated signals. An output of the multiplexer 380 includes a single multiplexed signal 383 that includes a plurality of *Mn* wavelengths, a subset 383A, 383B, 383C, 383D of which are drawn in Figure 3. In the embodiment of Figure 3, P, a number of PIC waveguides, is *Mn*; N, a number of external laser cavities, a number of laser cavities, and a number of gain chip waveguides, is *Mn*; B, a number of DBR rings, is *Mn*.

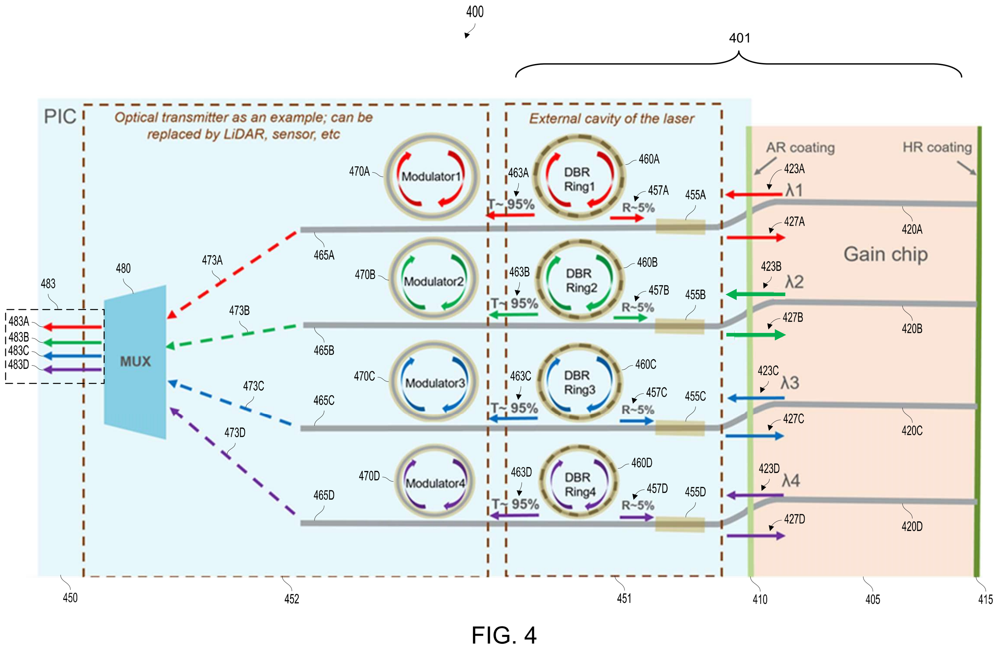

Refer now to the embodiment of Figure 4 which shows an alternative implementation of an electro-optical system 400 that includes a multiple-wavelength laser source 401. The embodiment of Figure 4 is similar to the embodiment of Figure 1. The embodiment of Figure 4 includes a gain chip 405 that is optically coupled to a PIC 450. Similar to the embodiment of Figure 1, the gain chip 405 in the embodiment of Figure 4 includes a first facet 410 and a second facet 415, wherein the first facet 410 coincides with a surface of optical coupling between the gain chip and the PIC, wherein the first facet is coated in an anti-reflective (AR) coating, wherein the second facet terminates a plurality of laser cavities, and wherein the second facet is coated in a highly reflective coating. In most embodiments, the gain chip 405 includes a first gain chip waveguide 420A, a second gain chip waveguide 420B, a third gain chip waveguide 420C, and a fourth gain chip waveguide 420D. In most embodiments, the gain chip waveguides 420A-D each form part of a laser cavity for a particular wavelength. In other embodiments, the gain chip may include a number of waveguides and a number of laser cavities greater than four or less than four. In most embodiments, a laser cavity includes a continuous reflection between terminations; in the embodiment of Figure 4, a continuous reflection is depicted for each laser cavity as an optical power moving in a direction toward the PIC and away from the gain chip, and an optical power moving in a direction away from the PIC and toward the gain chip.

For example, a first laser cavity includes optical power 423A from the gain chip and optical power 427A from the PIC, a second laser cavity includes optical power 423B from the gain chip and optical power 427B from the PIC, a third laser cavity includes optical power 423C from the gain chip and optical power 427C from the PIC, and a fourth laser cavity includes optical power 423D from the gain chip and optical power 427D from the PIC. In most embodiments, the PIC 450 includes an external cavity region 451 and a transmitter region 452. In some embodiments, the transmitter region 452 may include a system-on-a-chip (SoC), a LiDAR system, optical sensors, or other optical components. In various embodiments, the PIC includes PIC waveguides 465A, 465B, 465C, 465D that form external portions of laser cavities and guide light to optical modulators. In most embodiments, the first laser cavity further includes a portion of the first PIC waveguide 465A, the second laser cavity further includes a portion of the second PIC waveguide 465B, the third laser cavity further includes a portion of the first PIC waveguide 465C, and the fourth laser cavity further includes a portion of the first PIC waveguide 465D. In most embodiments, the first laser cavity further includes a first TOPS 455A, the second laser cavity further includes a second TOPS 455B, the third laser cavity further includes a third TOPS 455C, and the fourth laser cavity further includes a fourth TOPS 455D.

A given system or electro-optical device of the disclosure may include one or more devices, the one or more devices disposed on or in the PIC. In some embodiments, another of the M sections is a device section that includes the one or more devices. The one or more devices is in optical communication with one or more of the P PIC waveguides. In various embodiments, the one or more devices is a sensor device or a LiDAR-based device.

Each of the TOPS elements 455A-D is operable to adjust a phase of light in a laser cavity, with or without adjusting DBR ring TOPS at the same time, to change the resonant wavelength, or to compensate for changes in a resonant frequency or wavelength due to changes in ambient temperature. Finally, in most embodiments, each laser cavity is terminated on a PIC side by a DBR ring. For example, the first laser cavity is terminated by a first DBR ring 460A, the second laser cavity is terminated by a second DBR ring 460B, the third laser cavity is terminated by a third DBR ring 460C, and the fourth laser cavity is terminated by a fourth DBR ring 460D. As in other embodiments, each DBR ring is operable, by a choice of design parameters, to tune an amount of reflection of optical power back into a laser cavity and an amount of transmission out of a laser cavity. For example, the first DBR ring 460A reflects optical power 457A into the first laser cavity and transmits optical power 463A out of the first laser cavity, the second DBR ring 460B reflects optical power 457B into the second laser cavity and transmits optical power 463B out of the second laser cavity, the third DBR ring 460C reflects optical power 457C into the third laser cavity and transmits optical power 463C out of the third laser cavity, and the fourth DBR ring 460D reflects optical power 457D into the fourth laser cavity and transmits optical power 463D out of the fourth laser cavity.

In the embodiment of Figure 4, a first optical ring modulator 470A is optically coupled to the first PIC waveguide 465A, a second optical ring modulator 470B is optically coupled to the second PIC waveguide 465B, a third optical ring modulator 470C is optically coupled to the third PIC waveguide 465C, and a fourth optical ring modulator 470D is optically coupled to the fourth PIC waveguide 465D. In various embodiments, a ring modulator includes a ring resonator, i.e. a circular or elliptical waveguide. In some embodiments, a ring modulator may further include a circular TOPS element or local heater on a fabrication layer above or below the ring modulator. A ring modulator transmits a modulated signal.

For example, the first ring modulator 470A transmits a first modulated signal 473A, the second ring modulator 470B transmits a second modulated signal 473B, the third ring modulator 470C transmits a third modulated signal 473C, and the fourth ring modulator 470D transmits a fourth modulated signal 473D. Finally, in most embodiments, the PIC 450 further includes a multiplexer 480 that multiplexes the modulated signals 473A-D to yield a single multiplexed output 483. The single multiplexed output 483 includes a first output wavelength 483A, a second output wavelength 483B, a third output wavelength 483C, and a fourth output wavelength 483D. With the system and components depicted and described relative to Figure 4, one significant advantage is that since the DBR rings and the ring modulators can be fabricated on the same PIC die and located closely to each other, usually they see very similar or even the same impact from factors that can change their resonant wavelengths, e.g., fabrication variations and/or ambient temperature change. Therefore, the resonant wavelengths of the paired DBR ring and the ring modulator can be naturally synchronized, without the need for high electrical power to tune the modulator ring to match its resonant wavelength with that of the laser, of which the lasing wavelength is decided by the DBR ring. In the embodiment of Figure 4 , P, a number of PIC waveguides, is four; N, a number of external laser cavities, a number of laser cavities, and a number of gain chip waveguides, is four; B, a number of DBR rings, is four.

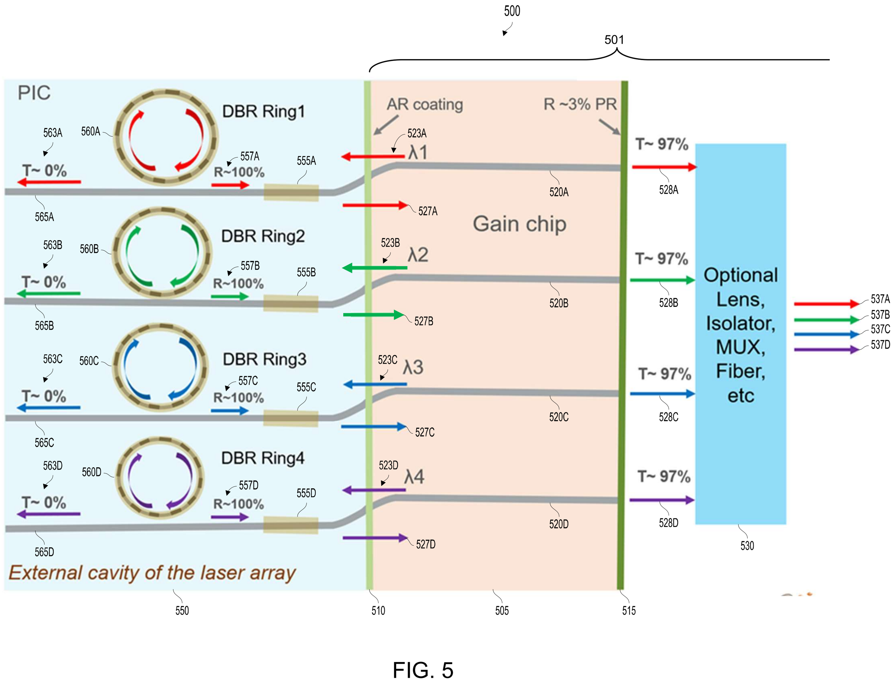

Refer now to the embodiment of Figure 5 which shows an alternative implementation of an electro-optical system 500 that includes a multiple-wavelength laser source 501. In some embodiments of the disclosure, a PIC that includes external portions of laser cavities may not include an optical transmitter or other optical elements beyond those that constitute the laser cavities. In such embodiments, the PIC may not include an optical output. In such embodiments a facet of a gain chip may be coated in a partially-reflective (PR) coating, yielding an optical output from the gain chip. The embodiment of Figure 5 includes a gain chip 505 and a PIC 550, wherein the gain chip is optically coupled to the PIC. The gain chip includes a first waveguide 520A that forms part of a first laser cavity, a second waveguide 520B that forms part of a second laser cavity, a third waveguide 520C that forms part of a third laser cavity, and a fourth waveguide 520D that forms part of a fourth laser cavity.

A laser cavity includes continuous reflection of optical power between at least two surfaces, facets, or terminations; for example, the first laser cavity reflects optical power 523A in a first direction and optical power 527A in a second direction, the second laser cavity reflects optical power 523B in a first direction and optical power 527B in a second direction, the third laser cavity reflects optical power 523C in a third direction and optical power 527C in a second direction, and the fourth laser cavity reflects optical power 523D in a first direction and optical power 527C in a second direction. The gain chip 505 includes a first facet 510 that coincides with a surface of optical coupling between the gain chip and the PIC. The first facet is coated in an anti-reflective (AR) coating. In several embodiments, the gain chip 505 further includes a second facet 515 that is coated with a partially-reflective (PR) coating. In the embodiment of Figure 5 and other embodiments, a PR coating may provide a reflectivity of more than about 1 % and less than about 20%.

With the use of a PR coating on the second facet 515, the gain chip may further include an optical output at the second facet for each laser cavity. For example, the first laser cavity includes an optical output power 528A, the second laser cavity includes an optical output power 528B, the third laser cavity includes an optical output power 528C, the fourth laser cavity includes an optical output power 528D. In some embodiments, the multiple-wavelength source 501 further includes an additional, off-chip optical element 530, such as an optical lens, an optical isolator, on optical multiplexer, an optical fiber, or other optical element. In some embodiments, the additional optical element 530 receives optical output powers 528A-D to yield a final output that includes an optical wavelength corresponding to each of the laser cavities. For example, a final output includes a first wavelength 537A, a second wavelength 537B, a third wavelength 537C, and a fourth wavelength 537D.

In some embodiments, one of the M sections is an external cavity section, wherein the external cavity section includes a portion of each of the P PIC waveguides and the B distributed Bragg reflector (DBR) rings. In some embodiments, a given electro-optical device of the disclosure may include an optical multiplexer, wherein another of the M sections is a modulator section that includes N modulators, wherein each modulator of the N modulators is in optical communication with one of the P PIC waveguides, wherein an optical output of each of the N modulators in in optical communication with an optical input of the multiplexer.

In various embodiments, the PIC 550 includes a first PIC waveguide 565A that forms an external part of the first laser cavity, a second PIC waveguide 565B that forms an external part of the second laser cavity, a third PIC waveguide 565C that forms an external part of the third laser cavity, and a fourth PIC waveguide 565D that forms an external part of the fourth laser cavity. A first TOPS element 555A overlaps a portion of the first PIC waveguide 565A, a second TOPS element 555B overlaps a portion of the second PIC waveguide 565B, a third TOPS element 555C overlaps a portion of the third PIC waveguide 565C, and a fourth TOPS element 555D overlaps a portion of the fourth PIC waveguide 565D. Each TOPS element 555A-D is operable, with or without adjusting the DBR ring TOPS at the same time, to adjust a phase of light in a laser cavity to change the resonant wavelength, or to compensate for changes in a resonant frequency or wavelength due to changes in ambient temperature.

In most embodiments, each laser cavity is terminated on a PIC side by a DBR ring. For example, the first laser cavity is terminated by a first DBR ring 560A, the second laser cavity is terminated by a second DBR ring 560B, the third laser cavity is terminated by a third DBR ring 560C, and the fourth laser cavity is terminated by a fourth DBR ring 560D. As in other embodiments, each DBR ring is operable, by a choice of design parameters, to tune an amount of reflection of optical power back into a laser cavity and an amount of transmission out of a laser cavity. For example, the first DBR ring 560A reflects optical power 557A into the first laser cavity and transmits optical power 563A out of the first laser cavity, the second DBR ring 560B reflects optical power 557B into the second laser cavity and transmits optical power 563B out of the second laser cavity, the third DBR ring 560C reflects optical power 557C into the third laser cavity and transmits optical power 563C out of the third laser cavity, and the fourth DBR ring 560D reflects optical power 557D into the fourth laser cavity and transmits optical power 563D out of the fourth laser cavity. In most embodiments, as the PIC 550 includes no additional, integrated optical elements beyond the laser cavities and the gain chip includes non-zero output optical powers that are transmitted off-chip, the optical powers 563A-D transmitted from the PIC 550 are about 0 % of optical powers in the laser cavities and the reflected optical powers 557A-D are about 100 % of optical powers in the laser cavities. In the embodiment of Figure 5 , P, a number of PIC waveguides, is four; N, a number of external laser cavities, a number of laser cavities, and a number of gain chip waveguides, is four; B, a number of DBR rings, is four.

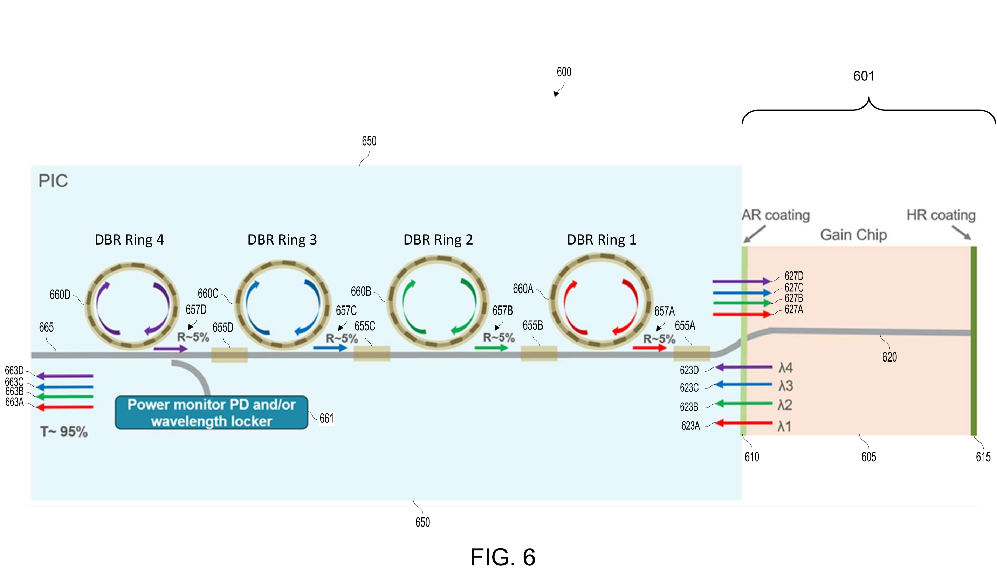

Refer now to the embodiment of Figure 6 which shows an alternative implementation of an electro-optical system 600 that includes a multiple-wavelength laser source 601. In some embodiments, such as the embodiment of Figure 6, a single, combined waveguide may span both a PIC and a gain chip and support multiple laser cavities. That is, a plurality of wavelengths may be multiplexed on a single waveguide that includes multiple laser cavities. As such, a plurality of DBR rings that terminate the multiple laser cavities may be arranged in series along the single waveguide, rather than in parallel. In some embodiments, a resonant wavelength of each DBR ring may be designed to match coarse wavelength division multiplexing (CDWM) grid requirements. In addition, a wavelength spacing can be designed to match wavelength division multiplexing (WDM) grids.

In the embodiment of Figure 6, a gain chip 605 is optically coupled to a PIC 650. The gain chip includes a waveguide 620 spanning a first facet 610 and a second facet 615. The PIC includes a waveguide 665. The first facet of the gain chip coincides with a surface of optical coupling between the gain chip and the PIC. The first facet of the gain chip also coincides with a point at which the gain chip waveguide 620 is optically coupled to the PIC waveguide 665, forming a single, combined waveguide that spans both the PIC and the gain chip, supporting multiple laser cavities, such as a first laser cavity, a second laser cavity, a third laser cavity, and a fourth laser cavity. In some embodiments, a number of laser cavities or a shared / common / combined laser cavity is supported by the single, combined waveguide. In most embodiments, the second facet of the gain chip is coated with a highly-reflective (HR) and terminates the laser cavities. The first facet of the gain chip is coated with an anti-reflective (AR) coating in most embodiments.

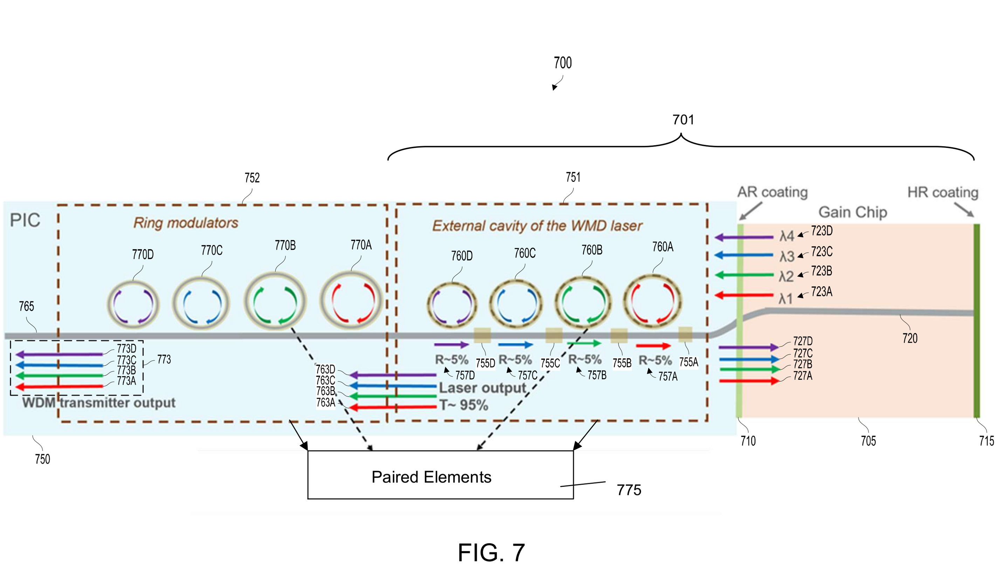

Refer now to the embodiment of Figure 7 which shows an alternative implementation of an electro-optical system 700 that includes a multiple-wavelength laser source 701. The embodiment of Figure 7 is similar to the embodiment of Figure 6, but the embodiment of Figure 7 further includes a series of ring modulators optically coupled to a PIC waveguide. The embodiment of Figure 7 includes a gain chip 705 that is optically coupled to a PIC 750. The gain chip includes a first facet 710 and a second facet 715, the first facet is coated with an AR coating and the second facet is coated with an HR coating. The gain chip includes a waveguide 720 spanning a first facet 710 and a second facet 715. The PIC includes an external cavity region 751, a modulator region 752, and a waveguide 765. The first facet of the gain chip coincides with a surface of optical coupling between the gain chip and the PIC. The first facet of the gain chip also coincides with a point at which the gain chip waveguide 720 is optically coupled to the PIC waveguide 765, forming a single, combined waveguide that spans both the PIC and the gain chip, supporting multiple laser cavities, such as a first laser cavity supporting a first wavelength, a second laser cavity supporting a second wavelength, a third laser cavity supporting a third wavelength, and a fourth laser cavity supporting a fourth wavelength.

A continuous reflection of optical power occurs in each laser cavity during device operation in various embodiments. In Figure 7 a first optical power 723A at a first wavelength travels in a first direction in the first laser cavity, a second optical power 723B at a second wavelength travels in a first direction in a first laser cavity, a third optical power 723C at a third wavelength travels in a first direction in a first laser cavity, and a fourth optical power 723D at a fourth wavelength travels in a first direction in a first laser cavity. Furthermore, a first optical power 727A at a first wavelength travels in a second direction in a first laser cavity, a second optical power 727B at a second wavelength travels in a second direction in a first laser cavity, a third optical power 627C at a third wavelength travels in a second direction in a first laser cavity, and a fourth optical power 627D at a fourth wavelength travels in a second direction in a first laser cavity. In various embodiments, a plurality of DBR rings, each optically coupled to the PIC waveguide 665 and arranged in series along the PIC waveguide, terminate light at various wavelengths terminating in a first laser cavity. For example, a first DBR ring 660A terminates a first wavelength in a first laser cavity, a second DBR ring 660B terminates a second wavelength in a first laser cavity, a third DBR ring 660C terminates a third wavelength in a first laser cavity, and a fourth DBR ring 660D terminates a fourth wavelength in a first laser cavity.

In various embodiments, a single, combined or shared waveguide such as waveguide 765 supports the plurality of laser cavities, such that each laser cavity overlaps with a portion of every other laser cavity at least with respect to waveguide 765. As in other embodiments, each DBR ring is operable, by a choice of design parameters, to tune an amount of reflection of optical power back into a laser cavity and an amount of transmission out of a laser cavity. For example, the first DBR ring 660A reflects an optical power 657A into a first laser cavity, the second DBR ring 760B reflects an optical power 657B into a first laser cavity, the third DBR ring 660C reflects an optical power 657C into a first laser cavity, and the fourth DBR ring 660D reflects an optical power 657D into a first laser cavity. Similarly, each DBR ring transmits an optical power out of a laser cavity.

For example, the first DBR ring 660A transmits an optical power 663A out of a first laser cavity, the second DBR ring 760B transmits an optical power 663B out of a first laser cavity, the first DBR ring 760C transmits an optical power 763C out of a first laser cavity, the fourth DBR ring 760D transmits an optical power 663D out of a first laser cavity. In various embodiments, an optical power transmitted by a DBR ring may be about 95 % of an optical power lasing in a laser cavity, and an amount of optical power reflected into a laser cavity by a DBR ring may be about 5 % of an optical power lasing in a laser cavity. In other embodiments, different proportions of optical power may be transmitted and reflected by a DBR ring. In various embodiments, the first laser cavity may be a common, combined or shared laser cavity or a portion thereof.

In most embodiments, a first laser cavity further includes a first TOPS 755A, a first laser cavity further includes a second TOPS 755B, a first laser cavity further includes a third TOPS 755C, and a first laser cavity further includes a fourth TOPS 755D. Each of the TOPS elements 755A-D is operable, with or without adjusting DBR ring TOPS at the same time, to adjust a phase of light in a laser cavity to adjust the resonant frequency, or to compensate for changes in a resonant frequency or wavelength due to changes in ambient temperature. Furthermore, in some embodiments, an optical photo detector, wavelength locker, or other optical element may be optically coupled to the shared waveguide 765. For example, in the embodiment of Figure 7 an optical element 761 is optically coupled to the shared waveguide 765. The common or shared waveguide 765 is also a PIC waveguide in various embodiments. In the embodiment of Figure 7, P, a number of PIC waveguides, is one; N, a number of external laser cavities, a number of laser cavities, and a number of gain chip waveguides, is one; B, a number of DBR rings, is four.

The devices disclosed herein may include wavelength locker in optical communication with the one PIC waveguide, wherein the PIC includes the wavelength locker. A power monitor in optical communication with the one PIC waveguide, wherein the PIC includes the power monitor may be implemented in various devices. A given device may include B modulator rings, wherein the B modulator rings are substantially aligned relative to the second axis.

In various embodiments, the external cavity region 751 of the PIC 750 includes an array of DBR rings that reflect or transmit light at various laser wavelengths. For example, a first DBR ring 760A reflects light of a first wavelength, a second DBR ring 760B reflects light of a second wavelength, a third DBR ring 760C reflects light of a third wavelength, and a fourth DBR ring 760D reflects light of a fourth wavelength. Additionally, the second facet of the gain chip terminates a laser cavity on a gain chip side. In many embodiments, optical powers 723A, 723B, 723C, 723D in a first direction and optical powers 727A, 727B, 727C, 727D in a second direction constitute a continuous reflection of optical powers in a laser cavity. In various embodiments, the first DBR ring 760A reflects an optical power 757A into a first laser cavity and transmits an optical power 763A out of a first laser cavity, the second DBR ring 760B reflects an optical power 757B into a first laser cavity and transmits an optical power 763B out of a first laser cavity, the third DBR ring 760C reflects an optical power 757C into a first laser cavity and transmits an optical power 763C out of a first laser cavity, the fourth DBR ring 760D reflects an optical power 757D into a first laser cavity and transmits an optical power 763D out of a first laser cavity.

In most embodiments, the first laser cavity further includes a first TOPS 755A, a first laser cavity further includes a second TOPS 755B, a first laser cavity further includes a third TOPS 755C, and a first laser cavity further includes a fourth TOPS 755D. Each of the TOPS elements 755A-D is operable to adjust a phase of light in a laser cavity to compensate for changes in a resonant frequency or wavelength due to changes in ambient temperature.

In addition, in most embodiments, the modulator region 752 includes an array of ring modulators, such as a first ring modulator 770A operable to modulate an optical signal of the first wavelength, a second ring modulator 770B operable to modulate an optical signal of the second wavelength, a third ring modulator 770C operable to modulate an optical signal of the third wavelength, and a fourth ring modulator 770D operable to modulate an optical signal of the fourth wavelength. Each of the ring modulators 770A-D are optically coupled to the PIC waveguide 765. In several embodiments, the ring modulators 770A-D are arranged in series along the PIC waveguide 765. In other embodiments, a subset of the ring modulators are fabricated on one side of the PIC waveguide 765 and a remainder of the ring modulators are fabricated on another side of the PIC waveguide. In most embodiments, a final optical output on the PIC includes a multiplexed signal 773 that includes or is composed of a modulated signal from each ring modulator. For example, the multiplexed signal 773 at the final output of the PIC includes a first modulated signal 773A at the first wavelength, a second modulated signal 773B at the second wavelength, a third modulated signal 773C at the third wavelength, and a fourth modulated signal 773D at the fourth wavelength.

In the embodiment of Figure 7 and other embodiments, a resonant wavelength of a DBR ring or a ring resonator may differ from a target or designed value due to changes in ambient temperature or due to fabrication process variations. However, due to an arrangement or a configuration of DBR rings and ring modulators in the embodiment of Figure 7 and other embodiments, changes to resonant wavelengths of DBR rings and ring modulators tend to be highly synchronized, and therefore in some embodiments all TOPS elements in thermal communication with all DBR rings and ring modulators may share a common digital-to-analog bias for synchronized tuning. In other embodiments, only a small amount of electrical power may be required to align resonant wavelengths of corresponding pairs of DBR rings and ring modulators.

For example, as shown ring modulator 770B and DBR ring 760B may be considered as exemplary paired elements 775. These two paired elements are in optical communication as arranged on adjacent sections, regions, or locations of the PIC. In addition, these two paired elements may be designed to handle the same wavelength(s) and have the same resonant wavelength. The close positioning of the pair elements on the PIC supports the paired elements being highly synchronized even under fabrication variations.

In general, any of the pairings or ring modulators with an external cavity element benefit from being on the same PIC and positioned relative to each other such that they are configured to be highly synchronized in response to their close proximity. In some embodiments, the separation distance between paired, such as a distance between a center of one ring and a center of another ring, for example, elements ranges from about 5 $\mu$m to about 10 mm. Ring modulator 770A and DBR ring 760A may be considered as exemplary paired elements 775. Ring modulator 770C and DBR ring 760C may be considered as exemplary paired elements 775. Ring modulator 770D and DBR ring 760D may be considered as exemplary paired elements 775. Various other elements that are replicated on a given PIC may also be treated as paired elements. In the embodiment of Figure 7 , P, a number of PIC waveguides, is one; N, a number of external laser cavities, a number of laser cavities, and a number of gain chip waveguides, is one; B, a number of DBR rings, is four.

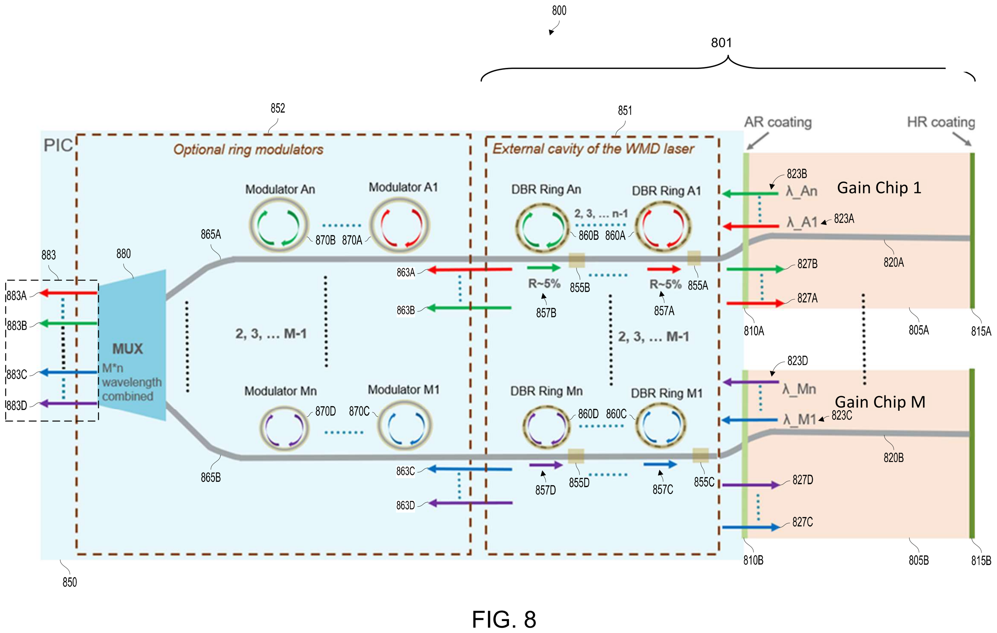

Refer now to the embodiment of Figure 8 which shows an alternative implementation of an electro-optical system 800 that includes a multiple-wavelength laser source 801. Depending on a gain bandwidth of a gain chip and requirement on WDM channel spacing and number, a design approach wherein multiple wavelengths are multiplexed on a single waveguide can be extended to consist of multiple gain chips, with each gain chip supports a comb of wavelengths for multiple channels. For example, a design of the embodiment of Figure 8 contains design motifs of the embodiments of Figures 3, 6, and 7, namely multiple gain chips, multiplexing of optical signals in overlapping laser cavities, and sequentially arranged DBR rings and ring modulators. The electro-optical system 800 includes a plurality of gain chips. A number of gain chips may be at least one, or at least two. The number of gain chips is denoted herein and in Figure 8 as *M*.

In Figure 8, a first gain chip 805A is drawn, and a last or *M* th gain chip 805B is drawn. The first gain chip 805A, the $M$ th gain chip 805B, and a remaining (not shown in Figure 8) $M$ - 2 gain chips are all optically coupled to a PIC 850. The first gain chip includes a first facet 810A and a second facet 815A, the $M$ th gain chip includes a first facet 810A and a second facet 810B, and each of the remaining $M$ - 2 gain chips include a first facet and a second facet. Each first facet of each gain chip coincides with a surface of optical coupling to the PIC 850, and each first facet of each gain chip is coated with an AR coating. Each second facet of each gain chip is coated with an HR coating. In most embodiments, the first gain chip 805A further includes a waveguide 820A spanning the first facet 810A of the first gain chip and the second facet 815A of the first gain chip; the second gain chip 805B further includes a waveguide 820B spanning the first facet 810A of the second gain chip and the second facet 815B of the second gain chip. Furthermore, each of the remaining $M$ - 2 gain chips further includes a waveguide spanning a first facet and a second facet. Each waveguide on each gain chip constitutes a portion of a laser cavity and each gain chip supports a plurality of wavelengths or carrier signals. A number of the plurality of wavelengths supported by $i$th gain chip, where $i$ = 1,..., $M$, may be denoted as $n_i$.

In various embodiments, a given facet, such as each second facet of each gain chip may terminate a laser cavity. Under normal operation of the multiple-wavelength laser source, each laser cavity exhibits a continuous reflection of optical powers between at least two terminations. For example, in Figure 8 the first gain chip 805A, supporting $n_1$ wavelengths, includes a first optical power 823A in a first direction, a last or $n_1$ th optical power 823B in a first direction, and a remaining $n_1$ - 2 optical powers in a first direction. The first gain chip 805A further includes a first optical power 827A in a second direction, a last or $n_1$ th optical power 827B in a second direction, and a remaining $n_1$ - 2 optical powers in a second direction. Furthermore, in Figure 8 the first gain chip 805B, supporting $n_M$ wavelengths, includes a first optical power 823C in a first direction, a last or $n_M$ th optical power 823D in a first direction, and a remaining $n_M$ - 2 optical powers in a first direction. The second gain chip 805B further includes a first optical power 827C in a second direction, a last or $n_M$ th optical power 827D in a second direction, and a remaining $n_M$ - 2 optical powers in a second direction.

In various embodiments, the PIC 850 includes an external cavity region 851 and a modulator region 852. The PIC further includes an array of $M$ waveguides. In at least one embodiment, the array of $M$ waveguides are substantially linear and parallel. In some embodiments, each waveguide of the $M$ PIC waveguides is optically coupled to one and only one of the $M$ gain chip waveguides and conversely, in some embodiments, each of the $M$ gain chip waveguides is optically coupled to one and only one of the $M$ PIC waveguides. In various other embodiments, a gain chip may include a number of waveguides greater than one, and various gain chip waveguides may be optically coupled to various PIC waveguides in arbitrary configurations such that each optical coupling couples a gain chip portion of a laser cavity to an external cavity portion of a laser cavity, forming a laser cavity supporting at least one optical wavelength. In the example embodiment of Figure 8 a first PIC waveguide 865A is optically coupled a waveguide 820A on the first gain chip and a last or $M$ th PIC waveguide 865B is optically coupled to a waveguide 820B on the last gain chip. Each of a remaining $M$ - 2 (not shown in Figure 8) PIC waveguides is optically coupled to a waveguide of a remaining $M$ - 2 gain chips.

In various embodiments, the external cavity region 851 includes a plurality of DBR rings. An $i$th PIC waveguide that completes $n_i$ laser cavities with an $i$th gain chip includes a plurality of $n_i$ DBR rings, each of which is coupled to the $i$th PIC waveguide. For example, in Figure 8, a first DBR ring 860A is optically coupled to the first PIC waveguide 865A and a last or $n_1$ th DBR ring 860B is optically coupled to the first PIC waveguide 865B. In addition, a remaining $n_1$ - 2 DBR rings are optically coupled to the first PIC waveguide 865A (not shown). Similarly, a first DBR ring 860C is optically coupled to the last PIC waveguide 865B and a last or $n_M$ th DBR ring 860D is optically coupled to the last PIC waveguide 865D. In addition, a remaining $n_M$ - 2 DBR rings are optically coupled to the last PIC waveguide 865B (not shown). Furthermore, $n_i$ DBR rings are optically coupled to $M$ - 2 PIC waveguides (not shown).

In various embodiments, such as the embodiment of Figure 8, each of the $n_1 + n_2 + ... + n_M$ DBR rings terminates a laser cavity by reflecting an optical power back into a laser cavity. As in other embodiments, each DBR ring is operable, by a choice of design parameters, to tune an amount of reflection of optical power back into a laser cavity and an amount of transmission out of a laser cavity. For example, in the Figure, a first DBR ring 860A optically coupled to the first PIC waveguide 865A reflects an optical power 857A back into a first laser cavity; in the Figure, a last or $n1$ th DBR ring 860B optically coupled to the first PIC waveguide 865A reflects an optical power 857B back into a last laser cavity. Each of a remaining $n_1$ - 2 DBR rings optically coupled to the first PIC waveguide 865A (not shown) similarly reflects an optical power back into a laser cavity.

Furthermore, a first DBR ring 860C optically coupled to the last PIC waveguide 865B reflects an optical power 857C back into a first laser cavity; in the Figure, a last or $n_M$ th DBR ring 860D optically coupled to the last PIC waveguide 865B reflects an optical power 857D back into a last laser cavity. Each of a remaining $n_M$ - 2 DBR rings (not shown) optically coupled to the last PIC waveguide 865B similarly reflects an optical power back into a laser cavity. Finally, each of a remaining $n_2 + n_3 + ... + n_{M-2} + n_{M-1}$ DBR rings optically coupled to one of a remaining $M$ - 2 PIC waveguides reflect an optical power back into a laser cavity.

In many embodiments, a remainder of an optical power not reflected by a DBR ring is transmitted into a modulator region 852. For example, as shown in Figure 8, an optical power 863A from a first laser cavity on the first PIC waveguide 865A is transmitted to the modulator region and an optical power 863B, from laser cavity including the first PIC waveguide, 865A is transmitted to the modulator region. An optical power, unlabeled in the Figure, from each of a remaining $n_1$ - 2 laser cavities on the first PIC waveguide 865A is transmitted to the modulator region. Furthermore, an optical power 863C from a first laser cavity on the last or $M$ th PIC waveguide 865B is transmitted to the modulator region and an optical power 863D from a laser cavity on the last or $M$ th PIC waveguide 865B is transmitted to the modulator region. An optical power, unlabeled in the Figure, from each of a remaining $n_M$ - 2 laser cavities on the last or $M$ th PIC waveguide PIC waveguide 865B is transmitted to the modulator region. Finally, a remaining $n_2 + n_3 + ... + n_{M-2} + n_{M-1}$ optical powers on a remaining $M$ - 2 waveguides are transmitted to the modulator region 852.

In many embodiments, a portion of each laser cavity may be in thermal communication with a TOPS element on the PIC. For example, as shown in Figure 8, a first TOPS element 855A fabricated in proximity to the first PIC waveguide 865A is in thermal communication with a laser cavity and a last TOPS element 855B fabricated in proximity to the first PIC waveguide 865A is in thermal communication with a laser cavity. Each of a remaining, unpictured $n_1$ - 2 TOPS elements fabricated in proximity to the first PIC waveguide 865A is in thermal communication with a laser cavity. Furthermore, a first TOPS element 855C fabricated in proximity to the last PIC waveguide 865B is in thermal communication with a laser cavity and a last TOPS element 855D fabricated in proximity to the last PIC waveguide 865B is in thermal communication with a laser cavity. Each of a remaining, unpictured $n_M$ - 2 TOPS elements fabricated in proximity to the last PIC waveguide 865B is in thermal communication with a laser cavity. Finally, each of a remaining $n_2 + n_3 + ... + n_{M-2} + n_{M-1}$ TOPS elements fabricated in proximity to one of a remaining $M$ - 2 PIC waveguides is in thermal communication with a laser cavity.

In various embodiments, each modulator of the N modulators include a loop waveguide having a first modulator loop dimension, wherein the first modulator loop dimension is approximately equal to the first loop dimension. The devices disclosed herein may include B thermo-optical phase shifters, wherein the first loop dimension is a diameter wherein the first modulator loop dimension is a diameter, wherein each of the B thermo-optical phase shifters is in thermal communication with one of the B DBR rings.

In some embodiments, one or more parameters of each of the DBR rings are one or both of a DBR grating coupling constant and a DBR ring coupling efficiency, wherein the DBR ring coupling efficiency ranges from about 5.0% to 95%, wherein the DBR grating coupling constant ranges from about 0.1 to about 100.

In the embodiment of Figure 8, the modulator region 852 includes a plurality of ring modulators. Each ring modulator is operable to modulate an optical signal at a particular wavelength. As each waveguide on the PIC multiplexes at least one wavelength, ring modulators are arranged in series along and optically coupled to each PIC waveguide. For example, as shown in Figure 8, a first ring modulator 870A optically coupled to the first PIC waveguide 865A modulates an optical signal at a first wavelength multiplexed in the first PIC waveguide; a last or $n_1$ th ring modulator 870B optically coupled to the first PIC waveguide 865A modulates an optical signal at a last or $n_1$ th wavelength multiplexed in the first PIC waveguide.

In various embodiments, each of a remaining but unpictured $n_1$ - 2 ring modulators optically coupled to the first PIC waveguide 865A modulates an optical signal at a $j$th ($j = 2,...,n_1$ - 1) wavelength multiplexed in the first PIC waveguide. Furthermore, a first ring modulator 870C optically coupled to the last or $M$ th PIC waveguide 865B modulates an optical signal at a first wavelength multiplexed in the last PIC waveguide; a last or $n_M$ th ring modulator 870D optically coupled to the last or $M$ th PIC waveguide 865B modulates an optical signal at a last or $n_M$ th wavelength multiplexed in the last PIC waveguide. Each of a remaining but unpictured $n_M$ - 2 ring modulators optically coupled to the last PIC waveguide 865B modulates an optical signal at a $j$th ($j = 2,...,n_M$ - 1) wavelength multiplexed in the last PIC waveguide. Finally, each of a remaining but unpictured $n_2 + n_3 + ... + n_{M-2} + n_{M-1}$ ring modulators modulates an optical signal at a wavelength multiplexed in one of a remaining $M$ - 2 PIC waveguides.

In most embodiments, $n_1$ modulated signals multiplexed in the first PIC waveguide, $n_M$ modulated signals multiplexed in the last PIC waveguide, and a remaining $n_2 + n_3 + ... + n_{M-2} + n_{M-1}$ modulated signals multiplexed in a remaining $M$ - 2 PIC waveguides are additionally multiplexed by a multiplexer 880, yielding a final multiplexed output signal 883. Shown in Figure 8 are a subset of $\sum_{i=1}^{M} n_i$ multiplexed modulated signals: a first multiplexed modulated signal 883A, an $n_1$ th multiplexed modulated signal 883B, an $\left(1 + \sum_{i=1}^{M-1} n_i\right)_{\text{th}}$ multiplexed modulated signal 883C, and an $\left(\sum_{i=1}^{M} n_i\right)_{\text{th}}$ multiplexed modulated signal 883D.

In the embodiment of Figure 8, P, a number of PIC waveguides, is $M$; N, a number of external laser cavities, a number of laser cavities, and a number of gain chip waveguides, is $M$; B, a number of DBR rings, is $\sum_{i=1}^{M} n_i$.

Note that in the embodiments shown in Figures 1, 3, 4, 5, 6, 7, and 8, gain chips are coupled to a PIC with an edge coupling approach, but in other embodiments, other integration methods are used, such as III-V to PIC die bonding, wafer bonding, III-V epitaxial growth on silicon, or other integration or coupling methods. Furthermore, in any embodiment disclosed herein utilizing a TOPS element in thermal communication with a DBR ring, a DBR ring may be fabricated in strong thermal isolation or in partial thermal isolation from a PIC, via, for example, a semiconductor etch fabrication process. In such embodiments, a thermal isolation of a DBR ring from a PIC improves a TOPS efficiency.

The diameter of the DBR ring may range from about 2.0 $\mu$m to about 2.0 mm. The optical path length or circumference of the DBR ring may range from about 6.0 $\mu$m to about 6.0 mm. In various embodiments, the length of PIC may range from about 0.2 mm to about 10.0 mm. In various embodiments, the width of PIC may range from about 0.2 mm to about 10.0 mm.

In some embodiments, the DBR ring is offset from waveguide by a separation distance. The separation distance may range from about 10 nm to about 1 $\mu$m in some embodiments. In embodiments where the DBR ring is designed such that all optical power is reflected toward the optical gain chip, a laser output is defined at or by the second facet of the optical gain chip or in optical communication with the second facet. In some embodiments, the DBR ring outputs coherent light having a central wavelength with a wavelength spread of $\pm$ about 8 nm. DBR coupling constant may range from about 0.1 to about 100, and the ring-to-waveguide coupling efficiency may range from about 5.0% to about 95%. In various embodiments, the DBR ring supports a laser cavity that lases at a single resonant mode.

In some embodiments, the optical gain chip further includes a first facet and a second facet, wherein the first facet is coated in a first coating, wherein the first facet defines N optical output ports, wherein each of the N gain chip waveguides is in optical communication with one of optical output port of the N optical output ports. The first coating may include an anti-reflective coating, a partially reflective coating, and/or a reflective coating. The second facet may be coated in a second coating such as an anti-reflective coating, a partially reflective coating, and/or a reflective coating.

Having thus described several aspects and embodiments of the technology of this application, it is to be appreciated that various alterations, modifications, and improvements will readily occur to those of ordinary skill in the art. Such alterations, modifications, and improvements are intended to be within the spirit and scope of the technology described in the application. It is, therefore, to be understood that the foregoing embodiments are presented by way of example only and that, within the scope of the appended claims and equivalents thereto, inventive embodiments may be practiced otherwise than as specifically described. In addition, any combination of two or more features, systems, articles, materials, and/or methods described herein, if such features, systems, articles, materials, and/or methods are not mutually inconsistent, is included within the scope of the present disclosure.

Also, as described, some aspects may be embodied as one or more methods. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

The phrase "and/or," as used herein in the specification and in the claims, should be understood to mean "either or both" of the elements so conjoined, i.e., elements that are conjunctively present in some cases and disjunctively present in other cases.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

The terms "approximately," "substantially" and "about" may be used to mean within $\pm$20% of a target value in some embodiments, within $\pm$10% of a target value in some embodiments, within $\pm$5% of a target value in some embodiments, and yet within $\pm$2% of a target value in some embodiments. The terms "approximately," "substantially," and "about" may include the target value.

In the claims, as well as in the specification above, all transitional phrases such as "comprising," "including," "carrying," "having," "containing," "involving," "holding," "composed of," and the like are to be understood to be open-ended, i.e., to mean including but not limited to. The transitional phrases "consisting of" and "consisting essentially of" shall be closed or semi-closed transitional phrases, respectively.

Where a range or list of values is provided, each intervening value between the upper and lower limits of that range or list of values is individually contemplated and is encompassed within the disclosure as if each value were specifically enumerated herein. In addition, smaller ranges between and including the upper and lower limits of a given range are contemplated and encompassed within the disclosure. The listing of exemplary values or ranges is not a disclaimer of other values or ranges between and including the upper and lower limits of a given range.

Embodiments disclosed herein may be embodied as a system, method or computer program product. Accordingly, embodiments may take the form of an entirely hardware embodiment, an entirely software embodiment (including firmware, resident software, microcode, etc.) or an embodiment combining software and hardware aspects that may all generally be referred to herein as a "circuit," "module," or "system." Furthermore, embodiments may take the form of a computer program product embodied in one or more computer readable medium(s) having computer readable program code embodied thereon.

## Claims

1. An electro-optical device comprising:

    an optical gain chip comprising; a gain material, the gain material having a gain region, the optical gain chip comprising:
    N gain chip waveguides;
    a photonic integrated circuit (PIC) comprising

       a plurality of layers and a plurality of components, wherein the PIC defines M sections;
       N external laser cavities;
       P PIC waveguides; and
       B distributed Bragg reflector (DBR) rings, wherein each of the N external laser cavities is defined by one of the P PIC waveguides and one of the B DBR rings; and

    N laser cavities, wherein each laser cavity of the N laser cavities comprises one of the N external laser cavities and one of the N gain chip waveguides.

2. The electro-optical device of claim 1, wherein N, M, P, and B are all positive integers greater than or equal to 2, wherein each laser cavity of the N laser cavities transmits one central wavelength that differs from a central wavelength transmitted by each of the laser cavities.

3. The electro-optical device of claim 2, wherein each DBR ring comprises:

    a loop waveguide optically coupled to one of the P PIC waveguides, wherein the loop waveguide has a first loop dimension; and
    one or more DBR disposed along one or more sections of the loop waveguide.

4. The electro-optical device of claim 3, wherein the optical gain chip further comprises a first facet and a second facet, wherein the first facet is coated in a first coating, wherein the first facet defines N optical output ports, wherein each of the N gain chip waveguides is in optical communication with one of optical output port of the N optical output ports.

5. The electro-optical device of claim 4, wherein the second facet is coated in a second coating, wherein the second coating is selected from a group consisting of an anti-reflective coating, a partially reflective coating, and a reflective coating.

6. The electro-optical device of claim 4 or 5, wherein the first coating is selected from a group consisting of an anti-reflective coating, a partially reflective coating, and a reflective coating.

7. The electro-optical device of claim 6, wherein one of the M sections is an external cavity section, wherein the external cavity section comprises a portion of each of the P PIC waveguides and the B distributed Bragg reflector (DBR) rings,

    optionally further comprising an optical multiplexer, wherein another of the M sections is a modulator section that comprises N modulators, wherein each modulator of the N modulators is in optical communication with one of the P PIC waveguides, wherein an optical output of each of the N modulators in in optical communication with an optical input of the multiplexer,
    further optionally wherein each modulator of the N modulators comprises a loop waveguide having a first modulator loop dimension, wherein the first modulator loop dimension is approximately equal to the first loop dimension,
    yet further optionally further comprising B thermo-optical phase shifters, wherein the first loop dimension is a diameter wherein the first modulator loop dimension is a diameter, wherein each of the B thermo-optical phase shifters is in thermal communication with one of the B DBR rings.

8. The electro-optical device of claim 6 or 7, wherein each of the B DBR rings is approximately circular and defines a DBR center, wherein all of the B DBR centers are approximately aligned with a first axis, wherein the first axis is approximately perpendicular to one or more of the P PIC waveguides.

9. The electro-optical device of claim 7 further comprising one or more devices, the one or more devices disposed on or in the PIC, wherein another of the M sections is a device section that comprises the one or more devices, wherein the one or more devices is in optical communication with one or more of the P PIC waveguides, wherein the one or more devices is a sensor device or a LiDAR-based device.

10. The electro-optical device of any preceding claim, wherein N is 1 and P is 1.

11. The electro-optical device of claim 10, wherein B distributed Bragg reflector (DBR) rings are substantially aligned relative to a second axis, wherein the second axis is substantially parallel with one PIC waveguide.

12. The electro-optical device of claim 11 further comprising B modulator rings, wherein the B modulator rings are substantially aligned relative to the second axis.

13. The electro-optical device of claim 11 or 12 further comprising a wavelength locker in optical communication with the one PIC waveguide, wherein the PIC comprises the wavelength locker, optionally further comprising a power monitor in optical communication with the one PIC waveguide, wherein the PIC comprises the power monitor.

14. A method comprising:

transmitting N laser beams back and forth between a gain chip and N external laser cavities, wherein the gain chip provides optical gain, wherein a wavelength of each of the N laser beams is tunable within a range;
selecting, using B DBR rings, a center wavelength from the range of wavelengths for each of the N laser beams;
transmitting N laser beams, each of the N laser beams having a selected center wavelength;
selecting, using one or more parameters of each of the B DBR rings, between a transmission direction and a reflection direction, wherein the transmission direction is orientable towards N laser outputs; and
transmitting each of the N laser beams having its respective selected center wavelength from one of the N laser outputs.

15. The method of claim 18, wherein at least one of:

A) the one or more parameters of each of the DBR rings are one or both of a DBR grating coupling constant and a DBR ring coupling efficiency, wherein the DBR ring coupling efficiency ranges from about 5.0% to 95%, wherein the DBR grating coupling constant ranges from about 0.1 to about 100;
B) the method further comprises tuning a TOPS in thermal communication with each of the B DBR ring such that a wavelength tuning range relative to the selected center wavelength is $\pm$ about 8 nm.

FIG. 1

FIG. 2

FIG. 3

FIG. 4

FIG. 5

EP 4 769 850 A2

FIG. 6

EP 4 769 850 A2

FIG. 7

FIG. 8